Europäisches Patentamt

European Patent Office

Office européen des brevets

(19)

(11) Publication number : **0 506 358 B1**

(12) **EUROPEAN PATENT SPECIFICATION**

(45) Date of publication of patent specification :
29.11.95 Bulletin 95/48

(51) Int. Cl.[6] : **G01R 13/34,** G01R 1/067E

(21) Application number : 92302558.9

(22) Date of filing : 25.03.92

(54) **Sampling-type optical voltage detector.**

(30) Priority : 26.03.91 JP 86244/91

(43) Date of publication of application :
30.09.92 Bulletin 92/40

(45) Publication of the grant of the patent :
29.11.95 Bulletin 95/48

(84) Designated Contracting States :
DE FR GB

(56) References cited :
EP-A- 0 299 427
GB-A- 2 212 265
IEEE JOURNAL OF QUANTUM ELECTRONICS
vol. QE-22, no. 1, January 1986, NEW YORK US
pages 69 - 78 VALDMANIS & MOUROU 'SUB-
PICOSECOND ELECTROOPTIC SAMPLING...'

(73) Proprietor : HAMAMATSU PHOTONICS K.K.
1126-1 Ichino-cho
Hamamatsu-shi
Shizuoka-ken (JP)

(72) Inventor : Takahashi, Hironori, c/o Hamamatsu
Photonics K.K.
1126-1 Ichino-Cho
Hamamatsu-shi, Shizuoka-ken (JP)
Inventor : Urakami, Tsuneyuki, c/o Hamamatsu
Photonics K.K.
1126-1 Ichino-Cho
Hamamatsu-shi, Shizuoka-ken (JP)
Inventor : Aoshima, Shinichiro, c/o
Hamamatsu Photonics K.K.
1126-1 Ichino-Cho
Hamamatsu-shi, Shizuoka-ken (JP)

(74) Representative : Rackham, Stephen Neil
GILL JENNINGS & EVERY,
Broadgate House,
7 Eldon Street
London EC2M 7LH (GB)

EP 0 506 358 B1

## Description

The present invention relates to a high-speed voltage detector utilizing an electrooptic crystal.

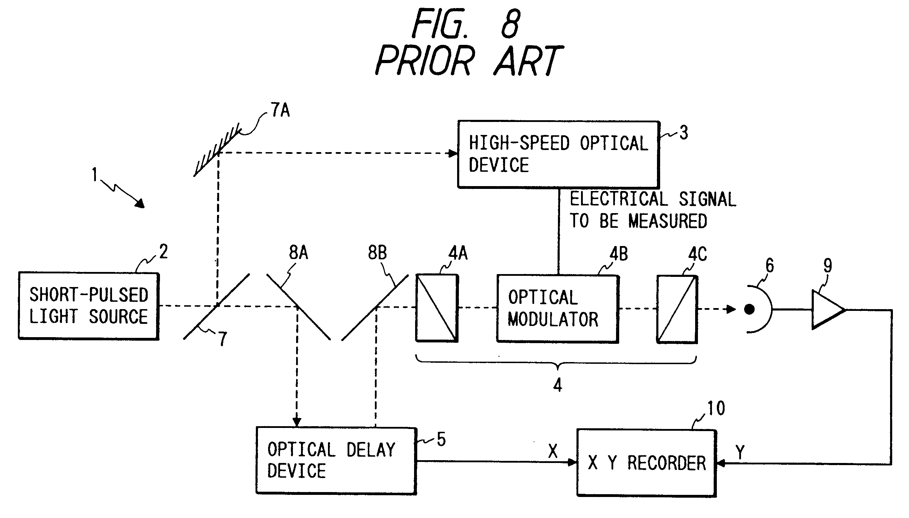

Fig. 8 shows a high-speed voltage detector 1 called an E-O sampling apparatus, which is a conventional example. The high-speed voltage detector 1 includes a short-pulsed light source 2, a high-speed optical device 3 such as a high-speed photodetector, a light intensity modulator 4 consisting of a polarizer 4A, optical modulator 4B and analyzer 4C, an optical delay device 5 and a photodetector 6. Short pulse light emitted from the short-pulsed light source 2 is split into two parts by a beam splitter 7. One part is input to the high-speed optical device 3, whose output is provided to the optical modulator 4B as an electrical signal to be measured. The other part from the beam splitter 7 is input to the optical delay device via a mirror 8A. Output light, which has been delayed by a predetermined time, is input, via a mirror 8B, to the light intensity modulator 4, where it is subjected to intensity modulation in accordance with the electrical signal (i.e., voltage) being applied to the optical modulator 4B and is passed through the analyzer 4C to reach the photodetector 6.

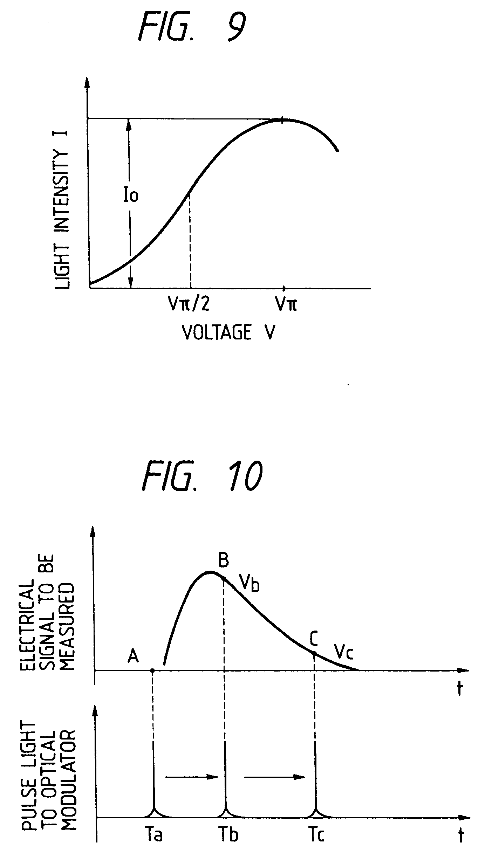

As shown in Fig. 9, the voltage V being applied to the optical modulator 4B and the intensity I of the light input to the photodetector 6 via the analyzer 4C has a relationship as represented by following equation (1):

$$I = I_0\sin^2\{(\pi/2)(V/V_\pi)\} \quad (1)$$

where $V_\pi$ is a half-wave voltage of the optical modulator 4B.

Therefore, the photodetector 6 detects the light whose intensity has been modulated by the electrical signal to be measured according to equation (1).

An output signal of the photodetector 6 is amplified by an amplifier 9, and then provided to an X/Y recorder 10. The X/Y recorder 10 reproduces the whole waveform of the electrical signal under measurement using a delay time signal X from the optical delay device 5 and a signal Y from the photodetector 6 while the delay time is continuously varied to change the sampling point. The principle of this measurement is described below in detail.

It is assumed that a waveform of the electrical signal to be measured and the input short pulse light to the optical modulator 4B has a relationship as shown in Fig.10. At delay time Ta (caused by the optical delay device 5 and measured from the reference time point), point A of the electrical signal is measured. Since the voltage is zero at delay time Ta, no change occurs in the output signal of the photodetector 6.

At delay time Tb, point B is measured to produce an output which depends on a voltage Vb. Similarly, at delay time Tc, a voltage Vc at point C is measured. In this manner, the whole waveform of the electrical signal is measured.

The optical delay device 5 can operate slowly and, as a benefit of the sampling-type measurement, it suffices that the photodetector 6 just follow the variation of the delay time. Therefore, the photodetector 6 can also have a slow response speed.

Since the optical modulator 4B operates very fast, the response speed of the voltage detector 1 is determined by a width of the pulse light emitted from the short-pulsed light source 2.

However, as shown in Fig. 9, in the high-speed voltage detector 1 the voltage V being applied to the optical modulator 4B and the intensity I of the output light from the analyzer 4C do not have a linear relationship. Therefore, in order to determine the voltage V from the light intensity I, a conversion reverse to the Fig. 9 characteristic needs to be performed. In doing so, however, in the range of small voltages V where the intensity I varies very little with respect to a variation of the voltage V, precise measurements can hardly be performed.

In order to solve this problem, usually a quarter-wave plate is disposed between the polarizer 4A and the analyzer 4C to provide an optical bias so as to establish an operating point at $V = V_\pi/2$, and measurements are performed while applying a small modulation voltage v ($<< V_\pi/2$) in the vicinity of the operating point. Since, in this case, an approximately linear relationship holds between the modulation voltage v and the modulated output light intensity I, a conversion reverse to the Fig. 9 characteristic is not required. However, this measurement method still has a problem that it only enables a measurement of a small voltage v ($<< V_\pi/2$). That is, this type of voltage detector cannot be applied to measurement of such a large voltage V as is about the same as or larger than the half-wave voltage $V_\pi$.

Further, in the high speed voltage detector 1, when the voltage V is gradually increased to reach $V_\pi$, the output light intensity I starts to decrease as understood from Figure 9, which also prevents correct measurements.

GB-A-2,212,265 exemplifies the type of conventional voltage detector described above.

The present invention has been made in view of the above problems of the prior art, and has an object of providing a high speed voltage detector which can readily measure not only a small voltage but a large voltage without performing an additional operation such as a conversion reverse to an input voltage-output light intensity characteristic.

According to the present invention, a voltage detector comprises:

pulsed light source means for emitting polarized light pulses;

modulating means for changing the polarization state of the polarized light pulses in accordance with the value of a voltage signal being applied to it;

means for gradually changing a phase relationship between the polarized light pulses and the voltage signal; and,

detecting means for determining a waveform of the voltage signal being applied to the modulating means;

and is characterised by a polarization interferometer coupled to the modulating means, for producing an interference fringe; and,

by the detecting means determining the waveform of the voltage signal based on movement of an interference fringe formed on an input surface of it and a phase-indicating signal provided from the phase relationship changing means.

With the above construction, the polarization interferometer means produces the interference fring in accordance with the polarization state of the light incident thereon, and the interference fringe moves in proportion to the value of the voltage signal. Since the voltage variation and the movement distance of the interference fringe have a linear relationship, it is not necessary to perform a conversion reverse to the input voltage-output light intensity characteristic of the conventional high speed voltage detector of Figure 8. This facilitates the voltage detection very much. Further, the good linearity provides highly precise measurements. In addition, the measurement can be performed irrespective of a value of a half-wave voltage of the modulating means.

Various embodiments of voltage detectors in accordance with this invention will now be described with reference to the accompanying drawings, in which:-

Fig. 1 is a block diagram showing part of a high speed voltage detector according to a first embodiment of the present invention;

Fig. 2 shows a polarization interferometer employed in the first embodiment;

Fig. 3 shows waveforms of output signals of a photodetector employed in the first embodiment;

Fig. 4 shows a polarization interferometer employed in a second embodiment;

Fig. 5 is a block diagram of a third embodiment;

Fig. 6 is a block diagram of a fourth embodiment;

Fig. 7 is a perspective view of a waveguide-type optical modulator employed in a fifth embodiment;

Fig. 8 is a block diagram showing a conventional high-speed voltage detector;

Fig. 9 is a graph showing a relationship between a voltage being applied to an optical modulator and intensity of output light from a photodetector, in the high-speed voltage detector of Fig. 8;

Fig. 10 includes waveforms to illustrate a relationship between pulse light incident on the optical modulator and an electrical signal to be measured, in the high-speed voltage detector of Fig. 8; and

Fig. 11 illustrates waveforms showing the output signal varies with large voltage changes.

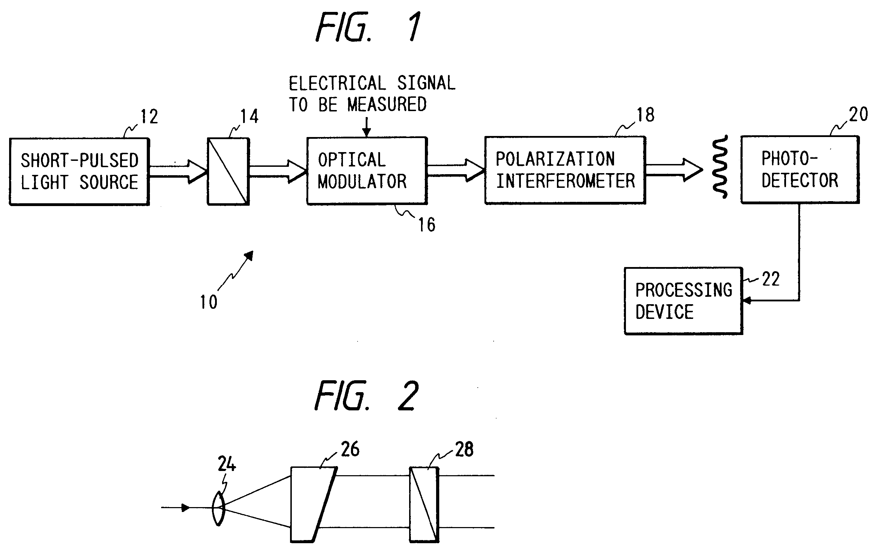

Fig. 1 shows a high-speed voltage detector 10 according to an embodiment of the invention. The voltage detector 10 includes a short-pulsed light source 12, a polarizer 14, an optical modulator 16 having an electrooptic crystal to which an electrical signal to be measured is applied, a polarization interferometer 18, a photodetector 20 for detecting output light from the polarization interferometer 18, and a processing device 22 for processing an output signal of the photodetector 20, which components are arranged in the above order from the short-pulsed light source 12. The electrical signal, i.e., voltage is detected while being sampled based on a movement distance of an interference fringe formed on the input surface of the photodetector 20, in which the interference fringe moves in accordance with the electrical signal being applied to the optical modulator 16. The polarizer 14 can be omitted if the pulsed light source 12 emits polarized pulse light.

As shown in Fig. 2, the polarization interferometer 18 includes an objective lens 24, birefringent crystal 26 and analyzer 28 which are arranged in this order. The analyzer 28 is so disposed that its polarizing direction forms an angle of 45° with the optic axis of the birefringent crystal 26.

The photodetector 20 is constituted of a one-dimensional CCD. The processing device 22 determines the voltage V based on equation (2) (described below) using intervals A and a movement distance X of peaks of the interference fringe that are obtained from an output signal of the photodetector 20.

The operation of the high-speed voltage detector 10 is described below.

Upon entrance into the polarization interferometer 18, polarized light is expanded by the objective lens 24, and then input to the birefringent crystal 26. In the birefringent crystal 26, the input light beam is split into two beams which have different polarization states in a direction determined by the optic axis of the crystal 26 and in a direction perpendicular thereto, and which travel along different paths. As a result, the two beams having an optical path difference are output from the polarization interferometer 18. Since, as described above, the analyzer 28 is so arranged that its polarizing direction forms an angle of 45° with the optic axis of the birefringent crystal 26, the two beams output from the birefringent crystal 26 and having orthogonal polarization states interfere each other after passing through the analyzer 28, and a resulting interference fringe is formed on the input surface of the photodetector 20.

On the other hand, the optical modulator 16 changes the polarization state of the light in accordance with the voltage being applied thereto, and provides the resulting light to the polarization interferometer 18. Therefore, the interference fringe, which is formed on the input surface of the photodetector 20 by the polarization interferometer 18, moves in proportion to the polarization state variation caused by the optical modulator 16, i.e., in proportion to the input voltage variation.

A movement distance X of the interference fringe is given by:

$$X = (A/2)(V/V_{\pi}) \quad (2)$$

where A represents an interval of adjacent peaks of the interference fringe, V the voltage being applied to the optical modulator 16, and $V_{\pi}$ the half-wave voltage.

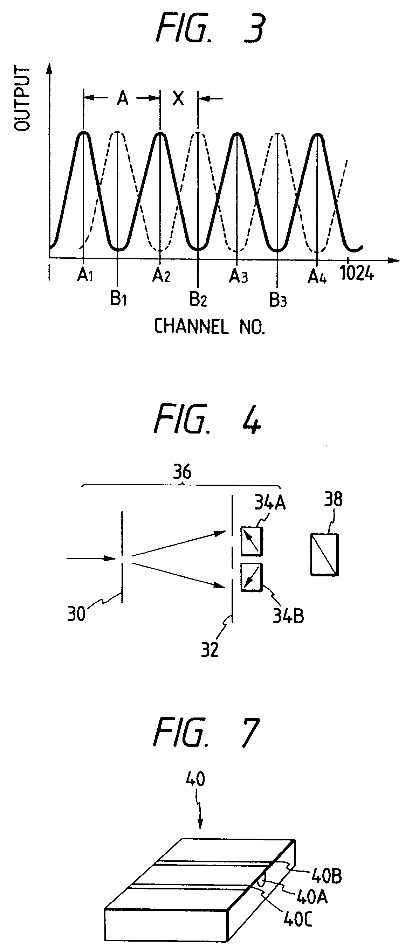

Fig. 3 shows an example of output signals of the photodetector 20 that is a one-dimensional CCD having 1,024 channels. The solid line of Fig. 3 represents an output signal caused by an interference fringe that is obtained when no voltage is applied to the optical modulator 16. The processing device 22 first determines channels A1-A4 of four peaks of the solid line waveform, and then determines an interval A between these channels A1-A4.

Then, a voltage is applied to the optical modulator 16, and channels B1-B4 of four peaks of an output signal (dashed line of Fig. 3) of the photodetector 20 caused by an interference fringe are determined, and a movement distance X of the interference fringe is determined by comparing the channels B1-B4 with the channels A1-A4 already obtained. The voltage V is finally calculated using equation (2) described above using the movement distance X thus determined.

The movement speed of the interference fringe, which is caused by a variation of the voltage being applied to the optical modulator 16, is determined by characteristics of the optical modulator 16, and is therefore very fast. However, since the voltage is measured while being sampled by means of short pulse light emitted from the light source 12, a fast-varying voltage can be measured even in the case where the response speed of the photodetector 20 is slow.

In the above embodiment, the movement distance X of the interference fringe can be measured more precisely if the output signal of the photodetector 20 is Fourier-converted and a phase of the Fourier-conversion signal is detected. Such an improvement in measurement precision, compared with the case of determining the voltage based on only the peaks of a signal representing the interference fringe, originates from the fact that the calculation is performed using every point of the signal.

While in the above embodiment the angle formed between the polarizing direction of the analyzer 28 and the optic axis of the birefringent crystal 26 is 45°, that angle is not limited to such a specific value, but may take any value as long as the two directions are not identical to or perpendicular to each other.

While in the above embodiment the polarization interferometer 18 includes the birefringent crystal 26, the interferometer 18 of the invention is not limited to this type, but may be of other types.

Fig. 4 shows an alternative polarization interferometer used in a second embodiment. This type of polarization interferometer includes Young's interferometer 36 consisting of a single slit 30 and a double slit 32. Slits of the double slit 32 extend in parallel with the single slit. Polarizer elements 34A and 34B are attached to the respective slits of the double slit 32 such that their polarizing directions form angles of + 45° and - 45° with the longitudinal direction of the single slit 30. Further, an analyzer 38 whose polarizing direction is in parallel with or perpendicular to that of the polarizer 14 is disposed on the output side of Young's interferometer 36.

Upon entrance into Young's interferometer 36, the output light from the optical modulator 16 is diffracted and spread by the single slit 30, and then reach the double slit 32. Since the polarizer elements 34A and 34B, that are provided on the double slit 32, have orthogonal polarizing directions, they produce light beams having orthogonal polarization states, which beams pass through the analyzer 38 and then interfere with each other. As a result, an interference fringe is formed on the input surface of the photodetector 20.

When a voltage is applied to the optical modulator 16, a phase difference between the two light beams having orthogonal polarization states is changed. The interference fringe moves in accordance with this variation of the phase difference.

An interval A of bands of the interference fringe is given by:

$$A = \lambda L/2d \quad (3)$$

where $\lambda$ represents a wavelength of light emitted from the light source 12, L a distance between the double slit 32 and the photodetector 20, and 2d an interval between the two slits of the double slit 32. Further, a movement distance X of the interference fringe is moved in proportion to the voltage V being applied to the optical modulator 14, and is expressed as:

$$X = (A/2)(V/V_{\pi}) \quad (4)$$

which has the same expression as equation (2) described above. The voltage can be obtained by determining the movement distance X based on equations (3) and (4) in the analyzing device 22.

While in the second embodiment of Fig. 4 the polarizing directions of the polarizer elements 34A and 34B form angles of + 45° and - 45° with the longitudinal direction of the single slit 30, those angles are not limited to such specific values, but may be any angles as long as the polarizing directions are not identical to the longitudinal direction of the single slit 30. Further, the analyzer 38 may have any polarizing direction as long as it does not coincide with one of the polarizing directions of the polarizer elements 34A and 34B.

In the first two embodiments means (not shown) are provided for gradually changing the phase relationship between the polarized light pulses and the voltage signal and for providing a phase indicating signal output. The phase indicating signal output is fed to the processing device 22. The means for gradually changing the phase relationship may be generally similar to those used in the prior art and as described with reference to Fig. 8.

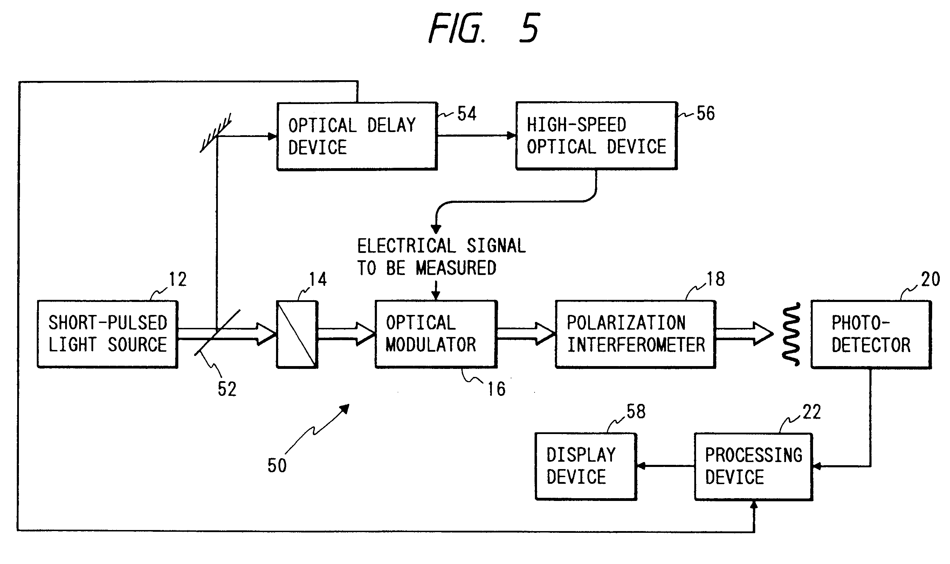

As shown in Fig. 5, in the third embodiment, an output signal of a high-speed optical device 56, that is produced when it receives short light pulse, is measured by a high-speed voltage detector 50. Light pulses emitted from a short-pulsed light source 12 is split into two beams by a half mirror 52. One of the two beams is input to a polarization interferometer 18 via a polarizer 14 and an optical modulator 16, and a resulting interference fringe is detected by a photodetector 20. An output signal of the photodetector 20 is sent to a processing device 22. The other beam is input to a high-speed optical device 56 via an optical delay device 54. An output signal of the high-speed optical device 56 as an electrical signal to be measured is input to the optical modulator 16. The electrical signal is detected based on a movement distance of the interference fringe in a manner similar to that already described in connection with the first embodiment of Fig. 1. In this embodiment, a signal indicating an optical delay produced by the optical delay device 54 is sent to the processing device 22, where it is used as a parameter of the X-axis when a waveform of the electrical signal is determined. In the processing device 22, the electrical signal is plotted as a Y-axis parameter. As a result, the waveform of the electrical signal determined in the processing device 22 is displayed on a display device 58.

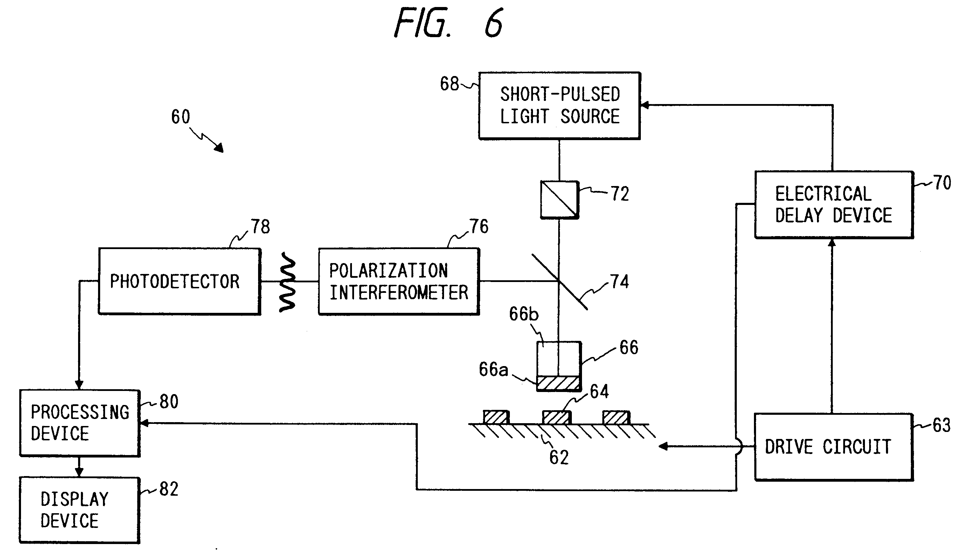

A fourth embodiment is shown in Fig. 6. In this embodiment an electrical device 62 to be subjected to measurement by a high-speed voltage detector 60 is driven by a drive circuit 63. An electrical signal of an electrode 64 on the electrical device 62 is measured using a non-contact-type optical modulator 66 which has an electrooptic material 66b and a mirror 66a formed thereon. Since the refractive index of the electrooptic material 66b is changed in accordance with a variation of electric lines of force from the electrode 64, the optical modulator 66 can change the polarization state of light input thereto.

A short-pulsed light source 68, such as a semiconductor laser, emits a light pulse on receiving an output signal of the drive circuit 63 via an electrical delay device 70. The pulse light from the pulsed light source 68 is input to the non-contact-type optical modulator 66 via a polarizer 72 and a half mirror 74, reflected by the mirror 66a of the optical modulator 66, then reflected by the half mirror 74, and finally enters a polarization interferometer 76. A resulting interference fringe is detected by a photodetector 78. An output signal of the photodetector 78 is provided to a processing device 80, where a waveform of the electrical signal is determined using a signal indicating the optical delay produced by the optical delay device 70. The waveform thus determined is displayed on a display device 82.

A fifth embodiment is intended to provide a small half-wave voltage $V_\pi$. As shown in Fig. 7, a waveguide-type optical modulator 40 is used as the optical modulator 16 of Fig. 1. According to the waveguide-type optical modulator 40, the half-wave voltage $V_\pi$ can be made as small as, for instance, 10 V by reducing an interval between electrodes 40B and 40C provided on both sides of a waveguide 40A to intensify an electric field developing in an electrooptic crystal and by elongating the electrodes 40B and 40C (so as to become longer than the width of the waveguide 40A) to increase the interaction length.

When the half-wave voltage $V_\pi$ has a small value, the ratio of the movement distance of the interference fringe to a variation of the voltage applied across the electrodes 40B and 40C becomes large, which enables highly precise measurements.

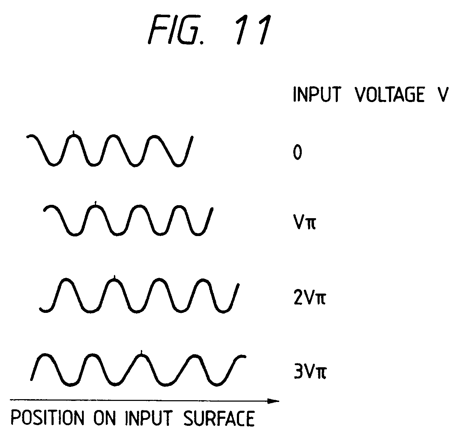

In the above embodiments, in analyzing the output signal of the photodetector 20 (i.e., one-dimensional CCD) in the processing device 22, one of its peaks of the output signal caused by the interference fringe may be picked up, and the movement distance of the interference fringe may be determined by examining movement of that particular peak, see Figure 11. Where the movement distance is so long that the peak under attention moves beyond the measurement range of the CCD, the peak to be examined may be changed to another one in the midst of the measurement. In this manner, the voltage detector can detect the voltage without any limitation on its upper value (with respect to the half-wave voltage).

In the invention, the photodetector 20 may be constituted of another type of detector, such as a one-dimensional image sensor and a two-dimensional image sensor (e.g., a CCD camera).

**Claims**

1. A voltage detector (10) comprising:

   pulsed light source means (12, 14) for emitting polarized light pulses;

   modulating means (16, 40) for changing the polarization state of the polarized light pulses in accordance with the value of a voltage signal being applied to it;

   means for gradually changing a phase relationship between the polarized light pulses and the voltage signal; and

   detecting means (20) for determining a waveform of the voltage signal being applied to the modulating means (16, 40);

characterised by a polarization interferometer (18, 36, 38), coupled to the modulating means (16, 40), for producing an interference fringe; and,

by the detecting means (20) determining the waveform of the voltage signal based on movement of an interference fringe formed on an input surface of it and a phase-indicating signal provided from the phase relationship changing means.

2. A voltage detector according to claim 1, wherein the detecting means (20) determines the waveform of the voltage signal further based on a pitch of the interference fringe.

3. A voltage detector according to claim 1 or 2, wherein the polarization interferometer (18) comprises a bire-fringent crystal (26) and an analyzer (28) disposed downstream of the birefringent crystal (26).

4. A voltage detector according to claim 1 or 2, wherein the polarization interferometer (36, 38) comprises a Young's interferometer (30, 32) which includes a single slit (30) and a double slit (32) which has two slits arranged in parallel with the single slit and polarizer elements (34A and 34B) attached to the two respective slits and having orthogonal polarizing directions, and an analyzer (38) disposed downstream of said Young's interferometer (30, 32).

5. A voltage detector according to claim 4, wherein the analyzer (38) is so arranged that its polarizing direction forms angles of + 45° and - 45° with the polarizing directions of the polarizer elements (34) of the double slit.

6. A voltage detector according to any one of the preceding claims, wherein the detecting means (20) comprises a one-dimensional CCD.

7. A voltage detector according to any one of the preceding claims, wherein the modulating means (16) comprises an electrooptical modulator.

8. A voltage detector according to claim 7, wherein the electrooptical modulator is of a waveguide type (40).

9. A voltage detector according to any one of the preceding claims, wherein the pulsed light source (12) means comprises a pulsed light source and a polarizer (14).

**Patentansprüche**

1. Spannungsdetektor (10), welcher umfaßt:
Impulslichtquellen-Mittel (12, 14) zum Emittieren polarisierter Lichtimpulse;
Modulierungsmittel (16, 40) zum Ändern des Polarisationszustandes der polarisierten Lichtimpulse entsprechend dem Wert eines daran angelegten Spannungssignals;
Mittel zum allmählichen Ändern einer Phasenbeziehung zwischen den polarisierten Lichtimpulsen und dem Spannungssignal; und
Erfassungsmittel (20) zum Bestimmen einer Wellenform des an das Modulierungsmittel (16, 40) angelegten Spannungssignals;
**dadurch gekennzeichnet,** daß ein Polarisations-Interferometer (18, 36, 38) mit dem Modulierungsmittel (16, 40) zur Erzeugung eines Interferenzstreifens gekoppelt ist; und
daß das Erfassungsmittel (20) die Wellenform des Spannungssignals erfaßt aufgrund der Bewegung eines an einer Eingabefläche desselben gebildeten Interferenzstreifens und eines von dem Phasenbeziehungs-Änderungsmittel geschaffenen, die Phase bezeichnenden Signals.

2. Spannungsdetektor nach Anspruch 1, bei dem das Erfassungsmittel (20) die Wellenform des Spannungssignals weiter aufgrund einer Schrittweite des Interferenzstreifens bestimmt.

3. Spannungsdetektor nach Anspruch 1 oder 2, bei dem das Polarisations-Interferometer (18) einen doppelbrechenden Kristall (26) und einen nach dem doppelbrechenden Kristall (26) angeordneten Analysator (28) umfaßt.

4. Spannungsdetektor nach Anspruch 1 oder 2, bei dem das Polarisations-Interferometer (36, 38) ein Young'sches Interferometer (30, 32) umfaßt, welches einen Einzelschlitz (30) und einen Doppelschlitz (32) enthält, bei dem zwei Schlitze parallel zu dem Einzelschlitz angeordnet sind und Polarisatorelemente (34A und 34B) an den beiden jeweiligen Schlitzen angebracht sind, mit orthogonalen Polarisations-Richtungen, und einen nach dem Young'schen Interferometer (30, 32) angeordneten Analysator (38).

5. Spannungsdetektor nach Anspruch 4, bei dem der Analysator (38) so ausgelegt ist, daß seine Polarisations-Richtung Winkel von +45° und -45° mit den Polarisations-Richtungen der Polarisatorelemente (34) des Doppelschlitzes bildet.

6. Spannungsdetektor nach einem der vorangehenden Ansprüche, bei dem das Erfassungsmittel (20) einen eindimensionalen CCD umfaßt.

**7.** Spannungsdetektor nach einem der vorangehenden Ansprüche, bei dem das Modulierungsmittel (16) einen elektrooptischen Modulator umfaßt.

**8.** Spannungsdetektor nach Anspruch 7, bei dem der elektrooptische Modulator von einem Wellenleitertyp (40) ist.

**9.** Spannungsdetektor nach einem der vorangehenden Ansprüche, bei dem die Impulslichtquellen-Mittel (12) eine Impulslichtquelle und einen Polarisator (14) umfaßt.

**Revendications**

**1.** Détecteur de tension (10), comprenant :

un moyen à source lumineuse pulsée (12, 14) pour émettre des impulsions lumineuses polarisées ;

un moyen de modulation (16, 40) pour changer l'état de polarisation des impulsions lumineuses polarisées selon la valeur d'un signal de tension qui lui est appliqué ;

un moyen pour faire varier progressivement une relation de phase entre les impulsions lumineuses polarisées et le signal de tension ; et,

un moyen de détection (20) pour déterminer une forme d'onde du signal de tension qui est appliqué au moyen de modulation (16, 40) ;

caractérisé par un interféromètre de polarisation (18, 36, 38), couplé au moyen de modulation (16, 40), pour produire une frange d'interférence ; et,

par le moyen de détection (20) qui détermine la forme d'onde du signal de tension selon le déplacement d'une frange d'interférence formée sur une surface d'entrée de celui-ci et un signal d'indication de phase fourni par le moyen pour faire varier la relation de phase.

**2.** Détecteur de tension selon la revendication 1, dans lequel le moyen de détection (20) détermine la forme d'onde du signal de tension en outre selon un pas de la frange d'interférence.

**3.** Détecteur de tension selon la revendication 1 ou la revendication 2, dans lequel l'interféromètre de polarisation (18) comprend un cristal biréfringent (26) et un analyseur (28) disposé en aval du cristal biréfringent (26).

**4.** Détecteur de tension selon la revendication 1 ou la revendication 2, dans lequel l'interféromètre de polarisation (36, 38) comprend un interféromètre de Young (30, 32) qui comprend une fente unique (30) et une fente double (32) qui comporte deux fentes disposées parallèlement à la fente unique et des éléments polariseurs (34A et 34B) liés aux deux fentes respectives et ayant des directions de polarisation orthogonales, et un analyseur (38) disposé en aval dudit interféromètre de Young (30, 32).

**5.** Détecteur de tension selon la revendication 4, dans lequel l'analyseur (38) est disposé de telle sorte que sa direction de polarisation forme des angles de +45° et -45° avec les directions de polarisation des éléments polariseurs (34) de la fente double.

**6.** Détecteur de tension selon l'une quelconque des revendications précédentes, dans lequel le moyen de détection (20) comprend un dispositif à transfert de charges CCD unidimensionnel.

**7.** Détecteur de tension selon l'une quelconque des revendications précédentes, dans lequel le moyen de modulation (16) comprend un modulateur électro-optique.

**8.** Détecteur de tension selon la revendication 7, dans lequel le modulateur électro-optique est de type guide d'ondes (40).

**9.** Détecteur de tension selon l'une quelconque des revendications précédentes, dans lequel le moyen à source lumineuse pulsée (12) comprend une source lumineuse pulsée et un polariseur (14).

## FIG. 1

SHORT-PULSED LIGHT SOURCE (12) → (14) → OPTICAL MODULATOR (16) → POLARIZATION INTERFEROMETER (18) → PHOTO-DETECTOR (20)

ELECTRICAL SIGNAL TO BE MEASURED

PHOTO-DETECTOR (20) → PROCESSING DEVICE (22)

10

## FIG. 2

24   26   28

EP 0 506 358 B1

# FIG. 3

# FIG. 4

# FIG. 7

FIG. 5

EP 0 506 358 B1

# FIG. 6

# FIG. 8
## PRIOR ART

HIGH-SPEED OPTICAL DEVICE ~3

ELECTRICAL SIGNAL TO BE MEASURED

7A

1

SHORT-PULSED LIGHT SOURCE ~2

8A  8B  4A  4B  4C

7

OPTICAL MODULATOR

4

6  9

OPTICAL DELAY DEVICE ~5

X

X Y RECORDER ~10

Y

EP 0 506 358 B1

# FIG. 9

# FIG. 10

# FIG. 11

INPUT VOLTAGE V

0

$V\pi$

$2V\pi$

$3V\pi$

POSITION ON INPUT SURFACE